# EUROPEAN PATENT APPLICATION

(11) **EP 4 145 522 A1**
(43) Date of publication of application: **08.03.2023**
(21) Application number: 20911298.6
(22) Date of filing: 22.06.2020
(51) Int. Cl.: H01L 27/32

(54) **DISPLAY PANEL AND DISPLAY APPARATUS**

(30) Priority: 27.04.2020 CN 202010341702
(71) Applicant: Wuhan China Star Optoelectronics Semiconductor Display Technology Co., Ltd., Wuhan, Hubei 430079 (CN)
(72) Inventor: FAN, Congcong, Wuhan Hubei 430079 (CN); LIU, Shengfang, Wuhan Hubei 430079 (CN)
(74) Representative: Stöckeler, Ferdinand
(86) International application number: PCT/CN2020/097387
(87) International publication number: WO 2021/217836

(57) **Abstract**

Disclosed are a display panel and a display apparatus. The display panel includes a plurality of display units arranged in an array, each of the display units including: a display device and a photosensitive device arranged in a same layer, wherein a light reflecting unit is provided at a side of each of the display units and is configured to partially reflect light emitted by the display device, to the photosensitive device to detect the light emitted by the display device to obtain brightness data.

## Description

### FIELD OF THE DISCLOSURE

The present application relates to display panel technologies, and more particularly to a display panel and display apparatus.

### DESCRIPTION OF RELATED ARTS

Compared to liquid crystal displays (LCDs), active-matrix organic light-emitting diode (AMOLED) displays have a lot of advantages: high contrast, ultra-thin, flexible and etc. However, for low temperature poly-silicon (LTPS) thin-film transistors (TFTs) manufactured on a large-scaled glass substrate, the TFTs in different positions often have non-uniformity in electrical parameters such as threshold voltage and mobility, due to limitation of a crystallizing process. This non-uniformity will eventually turn into a current difference and a brightness difference of an OLED display device and will be perceived by human eyes, that is, a Mura phenomenon (uneven displayed brightness). In addition, although better uniformity is achieved by processes for manufacturing Oxide TFTs, their threshold voltages will drift under prolonged pressure and high temperature. This is similar to amorphous silicon (a-Si) TFTs. Different amount by which the threshold voltages of TFTs at different parts of a display panel drift due to different displayed pictures will result in a difference of displayed brightness. Since this difference is related to preceding displayed images, it is often directed to a residual image phenomenon and it is commonly referred to as a ghost image.

Therefore, no matter LTPS TFT or Oxide TFT technology, there is a problem of uniformity or stability in current manufacturing processes, and the brightness of OLED itself will gradually decrease as the working time increases. These display problems are difficult to be completely overcome by manufacturing processes. Generally, various compensation techniques are designed and adopted to eliminate the influence of above factors, eventually to make the brightness of all pixels realize an ideal value. At present, commonly-used compensation techniques are classified into internal compensation and external compensation.

The internal compensation is to store the threshold voltage (Vth) of a TFT in its gate-source voltage (Vgs) at a compensation phase and turn Vgs-Vth into a current in emitting light. Since Vgs has already involved Vth, the influence of Vth is canceled out during the current conversion, thereby realizing consistency of the current. However, in practical, Vth cannot be completely canceled out because of the influence of parasitic parameter and driving speed. That is, when deviation of Vth exceeds a certain range (usually ΔVth≥0.5V), consistency of the current cannot be guaranteed. The internal compensation is restricted to a certain extent. Based on ways to extract data, the external compensation can be divided into optical extraction (Demura, optical compensation) and electrical extraction. The optical extraction is to extract brightness signals by using an optical charge-coupled device (CCD) after a back panel is activated to emit light; the electrical extraction is to extract electrical signals of TFT and OLED by using a sensing circuit of a driving chip. The types of signals extracted by the two techniques are different from each other and accordingly, data processing techniques are different as well. The optical extraction is simple in structure and flexible, and it is therefore widely used at present.

Traditional Demura compensation requires sophisticated peripheral equipments (e.g., automated optical inspection (AOI)) and this makes the compensation more complicated. In addition, the traditional Demura compensation is restricted to be used in a factory of a display panel manufacturer, and uneven brightness caused by device aging brought during repeated use of the display panel, cannot be compensated for the second time. This reduces reliability of the products to a certain extent. Therefore, there is an urgent need to develop a technology that enables Demura compensation performed on the display panel in real time.

### TECHNICAL PROBLEMS

The present application provides a display panel and a display apparatus, capable of detecting brightness data of each display unit of the display panel in real time by disposing a photosensitive device corresponding to a display device in each display unit, facilitating performing brightness compensation on the display panel in real time.

### TECHNICAL SOLUTIONS

In a first aspect, the present application provides a display panel, including a plurality of display units arranged in an array, each of the display units including: a display device and a photosensitive device arranged in a same layer,
wherein a light reflecting unit is provided at a side of each of the display units and is configured to partially reflect light emitted by the display device, to the photosensitive device to detect the light emitted by the display device to obtain brightness data.

In the display panel provided in the present application, each of the display units further includes a spacer unit located between the display device and the photosensitive device, and the light reflecting unit is disposed corresponding to the spacer unit.

In the display panel provided in the present application, a light shielding unit is disposed at a side of the light reflecting unit away from the spacer unit.

In the display panel provided in the present application, the light shielding unit is disposed corresponding to the photosensitive device.

In the display panel provided in the present application, a light transmitting unit is disposed at a side of each of the display units and disposed corresponding to the display device, wherein the light transmitting unit and the light shielding unit are disposed at a same layer.

In the display panel provided in the present application, a side surface of the light reflecting unit close to the spacer layer is a concave arc surface.

In the display panel provided in the present application, the photosensitive device includes any of an organic photodiode, an amorphous silicon device and a complementary metal oxide semiconductor device.

In the display panel provided in the present application, the display device includes an organic electroluminescent device.

In the display panel provided in the present application, a first thin-film transistor and a second thin-film transistor are disposed at a side of each of the display units away from the light reflecting unit, wherein the first thin-film transistor is connected to the display device and the second thin-film transistor is connected to the photosensitive device.

In a second aspect, the present application further provides a display panel, including a plurality of display units arranged in an array, each of the display units including: a display device, a photosensitive device and a spacer unit disposed between the display device and the photosensitive device, wherein the display device, the photosensitive device and the spacer unit are arranged in a same layer;
a light reflecting unit disposed at a side of each of the display units and disposed corresponding to the spacer unit, wherein a side surface of the light reflecting unit close to the spacer layer is a concave arc surface and the light reflecting unit is configured to partially reflect light emitted by the display device, to the photosensitive device to detect the light emitted by the display device to obtain brightness data;
a light shielding unit disposed at a side of the light reflecting unit away from the spacer unit; and a light transmitting unit disposed at a side of each of the display units and disposed corresponding to the display device, wherein the light transmitting unit and the light shielding unit are disposed at a same layer.

In a third aspect, the present application further provides a display apparatus, which includes a display device, a brightness compensation module and a driving module;
the display panel including a plurality of display units arranged in an array, each of the display units including: a display device and a photosensitive device arranged in a same layer, wherein a light reflecting unit is provided at a side of each of the display units and is configured to partially reflect light emitted by the display device, to the photosensitive device to detect the light emitted by the display device to obtain brightness data;
the brightness compensation module connected to the photosensitive device of each of the display units and configured to obtain the brightness data and output brightness compensation data based on the brightness data; and
the driving module having one end connected to the brightness compensation module and another end connected to the display panel, configured to perform brightness compensation on the display panel based on the brightness compensation data.

In the display apparatus provided in the present application, the display apparatus further includes a storing module, wherein one end of the storing module is connected to the brightness compensation module and another end of the storing module is connected to the driving module.

In the display apparatus provided in the present application, each of the display units further includes a spacer unit located between the display device and the photosensitive device, and the light reflecting unit is disposed corresponding to the spacer unit.

In the display apparatus provided in the present application, a light shielding unit is disposed at a side of the light reflecting unit away from the spacer unit.

In the display apparatus provided in the present application, the light shielding unit is disposed corresponding to the photosensitive device.

In the display apparatus provided in the present application, a light transmitting unit is disposed at a side of each of the display units and disposed corresponding to the display device, wherein the light transmitting unit and the light shielding unit are disposed at a same layer.

In the display apparatus provided in the present application, a side surface of the light reflecting unit close to the spacer layer is a concave arc surface.

In the display apparatus provided in the present application, the photosensitive device includes any of an organic photodiode, an amorphous silicon device and a complementary metal oxide semiconductor device.

In the display apparatus provided in the present application, the display device includes an organic electroluminescent device.

In the display apparatus provided in the present application, a first thin-film transistor and a second thin-film transistor are disposed at a side of each of the display units away from the light reflecting unit, wherein the first thin-film transistor is connected to the display device and the second thin-film transistor is connected to the photosensitive device.

### BENEFICIAL EFFECTS

In the display panel and the display apparatus provided in the present application, compared to obtaining actual brightness of the display panel 1 by sophisticated peripheral equipments in existing arts, the present application integrates the photosensitive device and the display device of each display unit into a same display panel. Also, each display device corresponds to one photosensitive device, and by a corresponding light reflecting unit, it can partially reflect the light emitted by each display device, to a corresponding photosensitive device to obtain brightness data of the light emitted by each display device. The brightness data of each display unit can be obtained without a need to use the sophisticated peripheral equipments. It is convenient in operation. Also, it can detect in real time whether the brightness of each display unit is abnormal, providing a reliable basis for brightness compensation. In the display apparatus provided in the present application, the brightness compensation module can analyze the brightness of each display device based on the brightness data outputted by each photosensitive device, and obtain a corresponding brightness compensation data by use of a compensation algorithm. The driving module can perform the brightness compensation on a corresponding display unit based on the brightness compensation data to achieve uniform brightness displaying. The brightness compensation can be performed in real time during use of the display apparatus, and brightness data detection and brightness compensation can be performed for many times. It ensures uniform brightness displaying, and improves reliability of product performance.

### DESCRIPTION OF DRAWINGS

The technical solutions and other beneficial effects of the present application will be more apparent with reference to the detailed descriptions of the embodiments of the present application below in accompanying with the drawings.
FIG. 1 is a top view of a plurality of display units of a display panel provided in an embodiment of the present application.
FIG. 2 is a sectional view of a display panel provided in an embodiment of the present application.
FIG. 3 is another sectional view of a display panel provided in an embodiment of the present application.
FIG. 4 is a structural schematic diagram illustrating a display apparatus provided in an embodiment of the present application.

### DESCRIPTION OF EMBODIMENTS OF THE DISCLOSURE

The technical solutions in the embodiments of the present application will be clearly and completely described below with reference to appended drawings of the embodiments of the present application. Obviously, the described embodiments are merely a part of embodiments of the present application and are not all of the embodiments. Based on the embodiments of the present application, all the other embodiments obtained by those of ordinary skill in the art without making any inventive effort are within the scope the present application.

In the description of the present application, it is to be understood that the terms "center", "longitudinal", "lateral", "length", "width", "thickness", "upper", "lower", "front", "rear", "left", "right", "vertical", "horizontal", "top", "bottom", "inner", "outer", "clockwise", "counterclockwise" and the like indicated orientation or positional relationship are based on the relationship of the position or orientation shown in the drawings, which is only for the purpose of facilitating description of the present application and simplifying the description, but is not intended to or implied that the device or element referred to must have a specific orientation, and be constructed and operated in a particular orientation. Therefore, it should not be construed as a limitation of the present application. In addition, the terms "first" and "second" are used for descriptive purposes only, and should not be taken to indicate or imply relative importance, or implicitly indicate the indicated number of technical features. Thus, by defining a feature with "first" or "second", it may explicitly or implicitly include one or more features. In the description of the present application, "a plurality" means two or more unless explicitly defined.

In the description of the present application, it should be noted that unless otherwise explicitly specified or limited, the terms "installed", "connected", and "connection" should be construed broadly, for example, a fixed connection, a removable connection, or integrally connected. These terms may be directed to a mechanical connection, and may also be directed to an electrical connection or communication. Moreover, these terms can be directed to "directly attached", "indirectly connected" through an intermediate medium, and may be directed to "internally communicated" with two components or the "interaction relationship" between two components. For persons skilled in the art, they can understand the specific meaning of the terms in the present application based on specific conditions.

In the present application, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on," "above," or "on top of" a second feature may include an embodiment in which the first feature is right or obliquely "on," "above," or "on top of" the second feature, or just means that the first feature is at a height higher than that of the second feature; while a first feature "below," "under," or "on bottom of" a second feature may include an embodiment in which the first feature is right or obliquely "below," "under," or "on bottom of" the second feature, or just means that the first feature is at a height lower than that of the second feature.

The following disclosure provides a plurality of different embodiments or examples to implement different structures of this application. To simplify the disclosure of this application, the following describes components and settings in particular examples. Certainly, the examples are merely for illustrative purposes, and are not intended to limit this application. In addition, in this application, reference numerals and/or reference letters may be repeated in different examples. This repetition is for the purpose of simplicity and clarity, and does not in itself indicate a relationship between the various embodiments and/or settings that are discussed. In addition, this application provides examples of various particular processes and materials, but a person of ordinary skill in the art will recognize that other processes and/or materials may be applied and/or used.

Traditional brightness compensation (Demura) includes the following major steps: activating a display panel by a driving chip to display several pictures (usually with grayscales or RGB); using a high-resolution and high-precision charge-coupled device (CCD) camera to shoot the aforesaid pictures; analyzing a color distribution of subpixels based on data collected by the camera and identifying Mura based on relevant algorithms; generating brightness compensation data based on actual brightness data, predetermined brightness data and a corresponding brightness compensation algorithm; and burning or writing the brightness compensation data to a flash ROM and performing brightness compensation on the display panel based on the brightness compensation data, and reshooting a compensated picture to confirm that Mura has been eliminated.

The traditional brightness compensation requires sophisticated peripheral equipments (e.g., AOI) and this makes the compensation more complicated. In addition, the traditional brightness compensation is restricted to be used in a factory of a display panel manufacturer, and uneven brightness caused by device aging brought during repeated use of the display panel, cannot be compensated for the second time. This reduces reliability of the products to a certain extent. Therefore, there is an urgent need to develop a technology that enables brightness compensation performed on the display panel in real time.

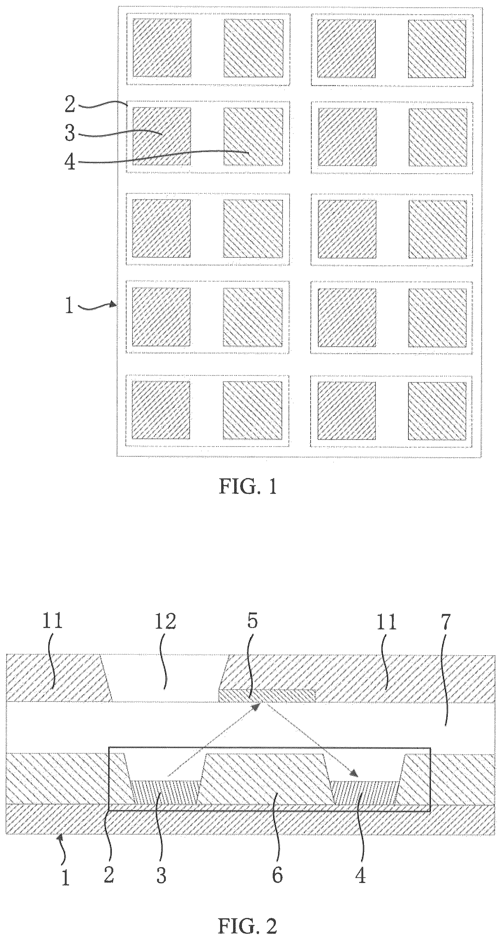

As shown in FIGs. 1 and 2, an embodiment of the present application provides a display panel 1, which includes a plurality of display units 2 arranged in an array. Each display unit 2 includes a display device 3 and a photosensitive device 4 arranged in a same layer. A light reflecting unit 5 is provided at a side of each display unit 2 (the light reflecting unit 5 is located at a light emitting side of the display unit 2) and is configured to partially reflect light emitted by the display device 3, to the photosensitive device 4 to detect the light emitted by the display device 3 to obtain brightness data.

Specifically, the display device 3 includes an organic electroluminescent device (e.g., an OLED). Of course, it can also be a micro light-emitting diode (micro LED) or of any other type of display device, and it is not limited herein. The photosensitive device 4 includes any of an organic photodiode (OPD), an amorphous silicon device and a complementary metal oxide semiconductor device. Of course, it can also be another photosensitive device capable of transforming a light signal into an electrical signal, and it is not limited herein. A material of the light reflecting unit 5 may include a light reflecting metal material.

Specifically, the photosensitive device can transform a received light signal into an electrical signal so as to detect the light emitted by a corresponding display device 3 to obtain its corresponding brightness data. It should be noted that a correspondence exists between the brightness data and the electrical signal, and various levels of electrical signals correspond to different brightness data. Therefore, the brightness data detected by the photosensitive device 4 is directed to actual brightness of the light emitted by the display device 3. Based on an analysis of and a comparison between the brightness data and a predetermined brightness data (which is the brightness displayed in a normal state), it can be determined whether there is a brightness difference, that is, whether there is Mura. It can provide a reliable basis for the brightness compensation.

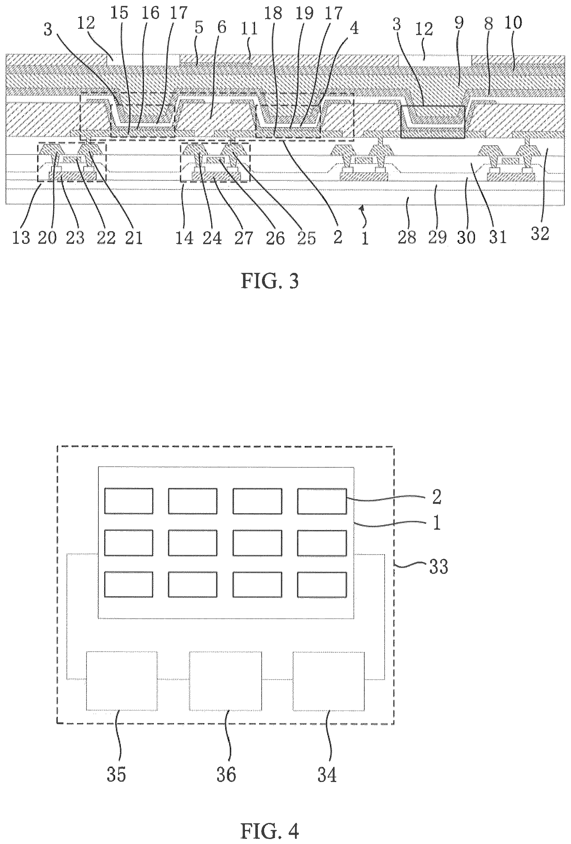

Specifically, each display unit 2 further includes a spacer unit 6 located between the display device 3 and the photosensitive device 4. The light reflecting unit 5 is disposed corresponding to the spacer unit 6. A thin-film encapsulating layer 7 is also provided between the light reflecting unit 5 and the display unit 2, and is configured to protect the display device 3 and the photosensitive device 4. As shown in FIG. 3, the thin-film encapsulating layer 7 includes a first inorganic encapsulating layer 8, an organic encapsulating layer 9 and a second inorganic encapsulating layer 10 sequentially disposed on the display unit 2. Of course, the spacer unit 6 is also provided between any two adjacent display units 2. A material of the spacer unit 6 includes a photoresist material.

Specifically, a light shielding unit 11 is also disposed at a side of each light reflecting unit 5 away from the spacer unit 6. A material of the light shielding unit 11 includes a material of a black color filter. In an embodiment, the light shielding unit 11 is also disposed corresponding to the photosensitive device 4, in order to prevent ambient light from interfering with the photosensitive device 4. It facilitates improving accuracy of the detected brightness data.

Specifically, as shown in FIG. 3, a first thin-film transistor 13 and a second thin-film transistor 14 are disposed at a side of each display unit 2 away from the light reflecting unit 5. The first thin-film transistor 13 is connected to the display device 3 and is configured to control operations of the display device 3. The second thin-film transistor 14 is connected to the photosensitive device 4 and is configured to output the brightness data.

Specifically, the display device 3 includes a first anode 15, and a light-emitting functional layer 16 and a cathode 17 sequentially disposed on the first anode 15. The photosensitive device 4 includes a second anode 18, and a photosensitive functional layer 19 and the cathode 17 sequentially disposed on the second anode 18. The first anode 15 and the second anode 18 have a same material, and the display device 3 and the photosensitive device 4 share a same cathode 17. The first thin-film transistor 13 includes a first source 20, a first drain 21, a first gate 22 and a first active layer 23, in which the first drain 21 and the first anode 15 are connected to each other via a via hole. The second thin-film transistor 14 includes a second source 24, a second drain 25, a second gate 26 and a second active layer 27, in which the second drain 25 and the second anode 18 are connected to each other via a via hole. The first source 20, the first drain 21, the second source 24 and the second drain 25 may be manufactured using a same material in a same manufacturing process. The first gate 22 and the second gate 26 may be manufactured using a same material in a same manufacturing process. The first active layer 23 and the second active layer 27 may be manufactured using a same material in a same manufacturing process.

Specifically, the display panel 1 further includes a substrate 28 and a water and oxygen blocking layer 29 disposed on the substrate 28. The first thin-film transistor 13 and the second thin-film transistor 14 are located on the water and oxygen blocking layer 29. The display panel 1 further includes a gate insulating layer 30 disposed between the first gate 22 and the first active layer 23 (or between the second gate 26 and the second active layer 27), an insulating interlayer 31 disposed between the first gate 22, and the first source 20 and the first drain 21 (or between the second gate 26, and the second source 24 and the second drain 25), and a flattening layer 32 disposed between the first source 20 and the first drain 21, and the first anode 15 (or between the second source 24 and the second drain 25, and the second anode 18). The spacer unit 6 is disposed on the flattening layer 32 and partially covers the first anode 15 and the second anode 18.

Compared to obtaining actual brightness of the display panel 1 by sophisticated peripheral equipments in existing arts, the embodiment of the present application integrates the photosensitive device 4 and the display device 3 of each display unit 2 into a same display panel 1. In the present embodiment, each display device 3 corresponds to one photosensitive device 4, and by a corresponding light reflecting unit 5, it can partially reflect the light emitted by each display device 3, to a corresponding photosensitive device 4 to obtain brightness data of the light emitted by each display device 3. The brightness data of each display unit 2 can be obtained without a need to use the sophisticated peripheral equipments. It is convenient in operation. Also, during use of the display panel 1, it can detect in real time whether the brightness of each display unit 2 is abnormal, providing a reliable basis for brightness compensation.

In an embodiment, a light transmitting unit 12 is disposed at a side of each display unit 2 and is disposed corresponding to the display device 3. The light transmitting unit 12 and the light shielding unit 11 are arranged in a same layer. Specifically, the light transmitting unit 12 has a property of selective transmission for light waves and plays a role of light filtering. Different display devices 3 may emit various colors of light, such as red light, green light and blue light. Correspondingly, the light transmitting unit 12 corresponding to the display device 3 emitting the red light only allows the red light to pass; the light transmitting unit 12 corresponding to the display device 3 emitting the green light only allows the green light to pass; the light transmitting unit 12 corresponding to the display device 3 emitting the blue light only allows the blue light to pass. The light transmitting unit 12 and the light shielding unit 11 constitute a color filter, which substitutes an original polarizer, that is, it is directed to a POL-Less technology, which is beneficial to reduce the thickness of the display panel 1.

In an embodiment, a surface side of the light reflecting unit 5 close to the spacer layer is a concave arc surface such that one photosensitive device 4 only receives a light signal emitted by one corresponding display device 3. This prevents the photosensitive device 4 from being interfered with or affected by the light signals emitted by other adjacent display devices 3. It facilitates improving accuracy of the brightness data.

As shown in FIG. 4, an embodiment of the present application further provides a display apparatus 33, which includes the display panel 1 according to above embodiments, a brightness compensation module 34 and a driving module 35. The brightness compensation module 34 is connected to the photosensitive device 4 of each display unit 2 and is configured to obtain the brightness data and output brightness compensation data based on the brightness data. The driving module 35 has one end connected to the brightness compensation module 34 and another end connected to the display panel, and is configured to perform brightness compensation on the display panel 1 based on the brightness compensation data. Specifically, the brightness compensation is performed on the display panel 1 for the display units 2 having uneven brightness, based on the brightness compensation data.

Specifically, after converting a light signal into an electrical signal, the photosensitive device 4 of each display unit 2 outputs the electrical signal to the brightness compensation module 34 by a corresponding second thin-film transistor 14. After obtaining the brightness data corresponding to each display unit 2, the brightness compensation module 34 performs an analysis based on predetermined brightness data (which is the brightness displayed in a normal state) of each display unit 2 to determine whether there is a brightness difference for each display unit 2, that is, performing a Mura recognition on the display panel 1. After that, brightness compensation data is outputted by use of a corresponding Demura compensation algorithm in accompanying with a driving current of the display panel 1.

Specifically, the display apparatus 33 further includes a storing module 36 such as a flash ROM. The storing module 36 has one end connected to the brightness compensation module 34 and another end connected to the driving module 35. The brightness compensation data outputted by the brightness compensation module 34 may be directly burned or written to the storing module 36. The driving module 35 includes a drive IC. The driving module 35 may directly read the brightness compensation data from the storing module 36 and perform the brightness compensation on the display unit 2 of the display panel 1 based on the brightness compensation data.

Specifically, the brightness compensation data includes position information and a compensation value for a to-be-compensated display unit 2. It should be noted that the brightness compensation data may include the position information and the compensation value for each display unit 2 and meanwhile, the compensation value for a display unit 2 that displays normally can be set as zero. Of course, the brightness compensation data may include only the position information and the compensation value for a display unit 2 having uneven brightness, and the present application is not limited herein.

Specifically, the brightness compensation module 34, the storing module 36 and the driving module 35 may be integrated on a same circuit board to reduce the size of the display apparatus 33.

Specifically, the display apparatus 33 of the present embodiment can perform, in real time, brightness data measurement, Mura recognition and brightness compensation to obtain a display effect of uniform brightness. Also, each display unit 2 of the display panel 1 that has been performed with the brightness compensation may be detected once again so as to estimate a result of the compensation. It can also perform the brightness compensation on the display panel 1 for many times eventually to achieve uniform brightness displaying. The present embodiment can perform the brightness compensation on the display panel 1 with a need to use peripheral equipments, and can perform the brightness compensation on the display panel 1 anywhere anytime. It is convenient in operation.

In the present embodiment, the brightness compensation module 34 can analyze the brightness of each display device based on the brightness data outputted by each photosensitive device 4, and obtain a corresponding brightness compensation data by use of a compensation algorithm. The driving module 35 can perform the brightness compensation on a corresponding display unit 2 based on the brightness compensation data to achieve uniform brightness displaying. The brightness compensation can be performed in real time during use of the display apparatus 33, and brightness data detection and brightness compensation can be performed for many times. It ensures uniform brightness displaying, and improves reliability of display panel 1 performance, that is, improving reliability of display apparatus 33 performance.

In the above embodiments, different emphasis is placed on respective embodiments, and reference may be made to related depictions in other embodiments for portions not detailed in a certain embodiment.

Hereinbefore, the display panel and the display apparatus provided in the embodiments of the present application are introduced in detail, the principles and implementations of the present application are set forth herein with reference to specific examples, descriptions of the above embodiments are merely served to assist in understanding the technical solutions and essential ideas of the present application. Those having ordinary skill in the art should understand that they still can modify technical solutions recited in the aforesaid embodiments or equivalently replace partial technical features therein; these modifications or substitutions do not make essence of corresponding technical solutions depart from the spirit and scope of technical solutions of embodiments of the present application.

## Claims

1. A display panel, comprising a plurality of display units arranged in an array, each of the display units comprising: a display device and a photosensitive device arranged in a same layer,
wherein a light reflecting unit is provided at a side of each of the display units and is configured to partially reflect light emitted by the display device, to the photosensitive device to detect the light emitted by the display device to obtain brightness data.

2. The display panel according to claim 1, wherein each of the display units further includes a spacer unit located between the display device and the photosensitive device, and the light reflecting unit is disposed corresponding to the spacer unit.

3. The display panel according to claim 2, further comprising a light shielding unit disposed at a side of the light reflecting unit away from the spacer unit.

4. The display panel according to claim 3, wherein the light shielding unit is disposed corresponding to the photosensitive device.

5. The display panel according to claim 3, further comprising a light transmitting unit disposed at a side of each of the display units and disposed corresponding to the display device, wherein the light transmitting unit and the light shielding unit are disposed at a same layer.

6. The display panel according to claim 2, wherein a side surface of the light reflecting unit close to the spacer layer is a concave arc surface.

7. The display panel according to claim 1, wherein the photosensitive device comprises any of an organic photodiode, an amorphous silicon device and a complementary metal oxide semiconductor device.

8. The display panel according to claim 1, wherein the display device comprises an organic electroluminescent diode.

9. The display panel according to claim 1, further comprising a first thin-film transistor and a second thin-film transistor disposed at a side of each of the display units away from the light reflecting unit, wherein the first thin-film transistor is connected to the display device and the second thin-film transistor is connected to the photosensitive device.

10. A display panel, comprising a plurality of display units arranged in an array, each of the display units comprising: a display device, a photosensitive device and a spacer unit disposed between the display device and the photosensitive device, wherein the display device, the photosensitive device and the spacer unit are arranged in a same layer;
a light reflecting unit disposed at a side of each of the display units and disposed corresponding to the spacer unit, wherein a side surface of the light reflecting unit close to the spacer layer is a concave arc surface and the light reflecting unit is configured to partially reflect light emitted by the display device, to the photosensitive device to detect the light emitted by the display device to obtain brightness data;
a light shielding unit disposed at a side of the light reflecting unit away from the spacer unit; and a light transmitting unit disposed at a side of each of the display units and disposed corresponding to the display device, wherein the light transmitting unit and the light shielding unit are disposed at a same layer.

11. A display apparatus, comprising the display panel according to claim 1, a brightness compensation module and a driving module;
the brightness compensation module connected to the photosensitive device of each of the display units and configured to obtain the brightness data and output brightness compensation data based on the brightness data; and
the driving module having one end connected to the brightness compensation module and another end connected to the display panel, configured to perform brightness compensation on the display panel based on the brightness compensation data.

12. The display apparatus according to claim 11, further comprising a storing module, wherein one end of the storing module is connected to the brightness compensation module and another end of the storing module is connected to the driving module.

13. The display apparatus according to claim 11, wherein each of the display units further includes a spacer unit located between the display device and the photosensitive device, and the light reflecting unit is disposed corresponding to the spacer unit.

14. The display apparatus according to claim 13, further comprising a light shielding unit disposed at a side of the light reflecting unit away from the spacer unit.

15. The display apparatus according to claim 14, wherein the light shielding unit is disposed corresponding to the photosensitive device.

16. The display apparatus according to claim 14, further comprising a light transmitting unit disposed at a side of each of the display units and disposed corresponding to the display device, wherein the light transmitting unit and the light shielding unit are disposed at a same layer.

17. The display apparatus according to claim 13, wherein a side surface of the light reflecting unit close to the spacer layer is a concave arc surface.

18. The display apparatus according to claim 11, wherein the photosensitive device comprises any of an organic photodiode, an amorphous silicon device and a complementary metal oxide semiconductor device.

19. The display apparatus according to claim 11, wherein the display device comprises an organic electroluminescent diode.

20. The display apparatus according to claim 11, further comprising a first thin-film transistor and a second thin-film transistor disposed at a side of each of the display units away from the light reflecting unit, wherein the first thin-film transistor is connected to the display device and the second thin-film transistor is connected to the photosensitive device.
